# DEMANDE DE BREVET EUROPEEN

(11) **EP 4 148 920 A1**
(43) Date de publication de la demande: **15.03.2023**
(21) Numéro de dépôt: 22194762.5
(22) Date de dépôt: 09.09.2022
(51) Int. Cl.: H02B 1/20, H01R 9/24, G01R 19/25, H01R 25/16

(54) **DISTRIBUTEUR DE COURANT ÉLECTRIQUE ET TABLEAU ÉLECTRIQUE**

(30) Priorité: 09.09.2021 FR 2109452
(71) Demandeur: Schneider Electric Industries SAS, 92500 Rueil-Malmaison (FR)
(72) Inventeur: BADIN, Didier, 38400 SAINT MARTIN D'HÈRES (FR); CHRISTOUD, Julien, 38000 GRENOBLE (FR); CERVELLIN, Lucas, 38760 VARCES (FR)
(74) Mandataire: Lavoix

(57) **Abrégé**

Distributeur de courant électrique (2) pour un tableau électrique, comprenant un bornier d'entrée (24), positionné à une extrémité primaire (22) et comprenant des borne d'entrées (25) connectées à des conducteurs internes du distributeur de courant électrique, et des borniers de distribution (41, 51), comprenant des bornes de distribution (42, 52) connectées aux conducteurs internes, pour alimenter des appareils de tête de groupe appartenant au tableau électrique. Pour que le distributeur de courant électrique soit évolutif et polyvalent, l'un des borniers de distribution constitue un bornier de distribution amovible (41), évoluant entre une configuration montée, où le bornier de distribution amovible est disposé entre le bornier d'entrée (24) et une extrémité secondaire (23), et où les bornes de distribution (42) du bornier de distribution amovible (41) sont reliées aux conducteurs internes, et une configuration libérée, où le bornier de distribution amovible est désolidarisé.

## Description

La présente invention concerne un distributeur de courant électrique et un tableau électrique comprenant un tel distributeur de courant électrique.

Un tableau électrique, équipant généralement une installation électrique desservant des locaux, vise à distribuer du courant électrique, fourni par un réseau électrique collectif, à différent circuits électriques de l'installation, tout en assurant une protection contre les risques électriques, voire en assurant d'autres fonctions auxiliaires, tel qu'un suivi de consommation. A ces circuits électriques, peuvent être connectés des appareils récepteurs, hors du tableau, tels que de l'éclairage, de l'électroménager, des appareils de chauffage et/ou des machines.

Le tableau comprend généralement un appareil de protection électrique principal, souvent appelé appareil de tête de tableau, par l'intermédiaire duquel le tableau électrique est alimenté en courant électrique depuis le réseau électrique collectif. Le tableau électrique comprend en outre des groupes d'appareils, généralement disposés selon des rangées. Le nombre, le type et l'agencement des appareils de ces groupes sont prévus en fonction des circuits électriques à alimenter et de la conception de l'installation électrique, de sorte que, d'un tableau électrique à l'autre, les appareils effectivement équipés et leur répartition peuvent être très différents. Chaque groupe comporte un appareil de protection électrique principal, généralement appelé « appareil de tête de groupe » et par l'intermédiaire duquel les autres appareils du groupe sont alimentés en énergie électrique, par exemple à l'aide d'un peigne. Ces autres appareils incluent le plus souvent des disjoncteurs divisionnaires, alimentant chacun un circuit électrique respectif de l'installation.

EP 3 503 318 A1 décrit un tableau électrique de ce type, en prévoyant que l'appareil de tête de tableau alimente les rangées d'appareillages par l'intermédiaire d'un dispositif de distribution du courant. Ce dispositif de distribution comprend des barres parallèles pour véhiculer le neutre et la phase en étant alimentées par l'appareil de tête de tableau, et supportant chacune des éléments de raccordement coopérant avec des bornes à connexion rapide, pour alimenter chaque appareil de tête de rangée.

Toutefois, puisque la disposition et le nombre de groupes d'appareils à alimenter peut être très différent d'une installation à l'autre, on prévoit généralement que le dispositif de distribution comprend un nombre élevé de bornes à connexion rapide pour couvrir à la fois les cas où le tableau comporte peu d'appareils et les cas où le tableau en comporte davantage. Lorsque le distributeur équipe un tableau avec peu de groupes d'appareils, de nombreuses bornes sont inutilisées.

L'invention vise notamment à résoudre ces inconvénient en proposant un nouveau distributeur de courant électrique évolutif et plus polyvalent.

L'invention a pour objet un distributeur de courant électrique pour un tableau électrique. Le distributeur de courant électrique comprend : un boîtier, qui comprend une extrémité primaire et une extrémité secondaire opposées ; des conducteurs internes, qui sont contenus dans le boîtier ; un bornier d'entrée, par l'intermédiaire duquel le distributeur de courant électrique est destiné à être alimenté avec du courant électrique, le bornier d'entrée étant solidaire du boîtier en étant positionné à l'extrémité primaire et comprenant, pour chaque conducteur interne, une borne d'entrée respective qui est électriquement reliée à ce conducteur interne ; et des borniers de distribution, chaque bornier de distribution comprenant, pour chaque conducteur interne, une borne de distribution respective, chaque bornier de distribution étant conçu pour alimenter un appareil de tête de groupe respectif appartenant au tableau électrique, avec du courant électrique reçu au bornier d'entrée, par l'intermédiaire des bornes de distribution dudit bornier de distribution.

Selon l'invention, au moins l'un des borniers de distribution constitue un bornier de distribution amovible, qui est configuré pour évoluer entre : une configuration montée, dans laquelle le bornier de distribution amovible est solidaire du boîtier, en étant disposé entre le bornier d'entrée et l'extrémité secondaire, et dans laquelle chaque borne de distribution du bornier de distribution amovible est électriquement reliée à l'un des conducteurs internes respectif pour que le bornier de distribution amovible soit alimenté avec du courant électrique reçu aux bornes d'entrée, et une configuration libérée, dans laquelle le bornier de distribution amovible est désolidarisé du boîtier et dans laquelle les bornes de distribution du bornier de distribution amovible sont électriquement déconnectées des conducteurs internes.

Une idée à la base de l'invention est que le distributeur de courant électrique peut être personnalisé, de préférence directement par un technicien qui installe et/ou modifie le tableau électrique. A cette fin, tout ou partie des borniers de distribution sont amovibles, de sorte à pouvoir individuellement équiper le distributeur de courant électrique ou en être retirés. De préférence, le distributeur de courant électrique est configuré pour que la mise en configuration montée ou libérée de chaque bornier de distribution amovible puisse être effectuée in situ, directement par le technicien. L'invention réduit donc la nécessité de fabriquer en usine des distributeurs de courant électrique de plusieurs tailles et configurations, ou de prévoir une quantité superflue de borniers de distribution, puisque le distributeur de courant électrique peut être personnalisé par le technicien, en fonction des besoins du tableau électrique.

En particulier, en fonction du nombre et de la disposition des groupes d'appareils au sein du tableau électrique, le technicien peut choisir d'ajouter un ou plusieurs borniers de distribution amovible au dispositif de distribution électrique, en mettant ces borniers de distribution amovibles en configuration montée, pour alimenter les appareils de tête de ces groupes d'appareils par l'intermédiaire de ces borniers de distribution amovibles. Le technicien peut alternativement choisir de mettre un ou plusieurs borniers de distribution amovibles en configuration libérée, c'est-à-dire de déséquiper le distributeur de courant électrique de ces borniers, par exemple lorsque les borniers de distribution restants sont suffisamment nombreux pour alimenter tous les groupes d'appareils du tableau. Le technicien peut choisir de faire passer un bornier de distribution amovible en configuration libérée lors que ce bornier de distribution amovible n'est pas disposé à un emplacement optimal par rapport à un groupe d'appareil à alimenter et qu'il est préférable d'alimenter ce groupe avec un autre bornier de distribution. En outre, alors que le tableau est déjà installé et qu'il est nécessaire de le modifier, par exemple par ajout, retrait ou modification d'un groupe d'appareils, un technicien peut modifier en conséquence le distributeur de courant électrique pour l'adapter aux groupes d'appareils du tableau, ce qui évite de devoir entièrement remplacer le distributeur de courant électrique. Alors, un bornier de distribution amovible peut avantageusement être mis en configuration montée ou libérée, sans action sur les autres borniers de distribution.

Un bornier de distribution amovible qui a été mis en configuration libérée d'un distributeur de courant donné peut avantageusement être utilisé pour équiper un autre distributeur de courant similaire, équipant un autre tableau électrique, en mettant le bornier de distribution amovible en configuration montée sur cet autre distributeur de courant électrique.

De manière avantageuse, la possibilité de faire passer en configuration montée ou libérée le bornier de distribution amovible permet avantageusement de remplacer individuellement un bornier de distribution amovible par un autre bornier de distribution amovible, lorsque le bornier de distribution amovible initial était défectueux, ou par un bornier de distribution amovible d'un autre type, par exemple adapté à l'alimentation d'un autre type d'appareil de tête de groupe, ou conforme à une autre norme. De manière avantageuse, comme expliqué ci-après, on peut aussi prévoir d'équiper le bornier de distribution amovible avec un module de surveillance amovible.

De préférence, le distributeur de courant électrique comprend, pour chaque borne de distribution du bornier de distribution amovible, un connecteur femelle respectif, qui est électriquement relié à l'un des conducteurs internes, que le bornier de distribution amovible soit en configuration montée ou en configuration libérée. De préférence, chaque borne de distribution du bornier de distribution amovible comprend un connecteur mâle respectif, chaque connecteur mâle formant préférentiellement une fiche respective et étant : électriquement connecté avec l'un des connecteurs femelle en étant enfiché dans ledit connecteur femelle, lorsque le bornier de distribution amovible est en configuration montée, pour relier électriquement la borne de distribution au conducteur interne auquel ledit connecteur femelle est électriquement relié, et électriquement déconnecté dudit connecteur femelle lorsque le bornier de distribution amovible est en configuration libérée.

De préférence, le distributeur de courant électrique comprend un module de surveillance, qui est configuré pour évoluer entre : une configuration installée, dans laquelle le module de surveillance est solidaire du boîtier et dans laquelle, lorsque le bornier de distribution amovible est en configuration montée, le module de surveillance est configuré pour mesurer une grandeur électrique aux bornes de distribution dudit bornier de distribution amovible, et une configuration désinstallée, dans laquelle le module de surveillance est désolidarisé du boîtier. De préférence, le bornier de distribution amovible est configuré pour pouvoir être en configuration montée, que le module de surveillance soit en configuration installée ou en configuration désinstallée.

De préférence, lorsque le module de surveillance est en configuration installée et que le bornier de distribution amovible est en configuration montée, le module de surveillance est intercalé entre le bornier de distribution amovible et les conducteurs internes.

De préférence, le module de surveillance comprend un conduit traversant.

De préférence, lorsque le bornier de distribution amovible est en configuration montée et que le module de surveillance est en configuration installée, le conduit traversant est traversé par l'une des bornes de distribution du bornier de distribution amovible.

De préférence, le module de surveillance comprend un capteur, qui est disposé le long du conduit traversant pour mesurer la grandeur électrique auprès de la borne de distribution qui traverse ledit conduit traversant.

De préférence, le module de surveillance comprend des connecteurs d'alimentation, chaque connecteur d'alimentation étant électriquement relié à l'un des conducteurs interne, lorsque le module de surveillance est en configuration installée, le module de surveillance étant alors alimenté avec du courant électrique reçu au bornier d'entrée par l'intermédiaire des conducteurs internes et des connecteurs d'alimentation.

De préférence, le distributeur de courant électrique comprend des moyens d'encliquetage, qui sont encliquetés pour maintenir le bornier de distribution amovible solidaire avec le boîtier lorsque le bornier de distribution amovible est en configuration montée, et qui peuvent être désencliquetés pour faire passer le bornier de distribution amovible en configuration libérée.

De préférence, au moins l'un des borniers de distribution constitue un bornier de distribution fixe, qui est solidaire du boîtier de façon permanente, en étant disposé entre le bornier d'entrée et l'extrémité secondaire.

De préférence, chaque borne de distribution du bornier de distribution fixe est électriquement reliée à l'un des conducteurs internes respectif, de façon permanente.

L'invention a également pour objet un tableau électrique, comprenant : un distributeur de courant électrique tel que défini ci-avant, et au moins un groupe d'appareils, chaque groupe d'appareils comprenant un appareil de tête de groupe respectif, par l'intermédiaire duquel le groupe d'appareils est électriquement relié aux bornes de distribution de l'un des borniers de distribution, pour que le groupe d'appareils soit alimenté avec de l'énergie électrique reçue aux bornes d'entrée par l'intermédiaire dudit bornier de distribution.

L'invention sera mieux comprise et d'autres avantages de celle-ci apparaîtront à la lumière de la description suivante, exposant des exemples conformes à son principe, illustrés par les dessins annexés suivants.
[Fig 1] La figure 1 est une vue de face d'un tableau électrique, selon un premier mode de réalisation conforme à l'invention.
[Fig 2] La figure 2 est une vue en perspective éclatée d'un distributeur de courant électrique appartenant au tableau électrique de la figure 1.
[Fig 3] La figure 3 est une vue en perspective d'une partie du distributeur de courant électrique des figures précédentes, montrant notamment un bornier de distribution amovible en configuration montée.
[Fig 4] La figure 4 est une vue similaire à celle de la figure 3, où le bornier de distribution amovible est omis, rendant visible un module de surveillance, montré en configuration installée.
[Fig 5] La figure 5 est une vue similaire à celles des figures figure 3 et 4, où le bornier de distribution amovible et le module de surveillance sont omis.
[Fig 6] La figure 6 est une vue similaire à celles des figures figure 3 à 5, où le bornier de distribution amovible, le module de surveillance et un socle sont omis.
[Fig 7] La figure 7 est une vue en perspective du bornier de distribution amovible des figures précédentes.
[Fig 8] La figure 8 est une vue en perspective du module de surveillance des figures précédentes.
[Fig 9] La figure 9 est une vue en perspective éclatée, similaire à la figure 2, d'un distributeur de courant électrique selon un deuxième mode de réalisation conforme à l'invention.

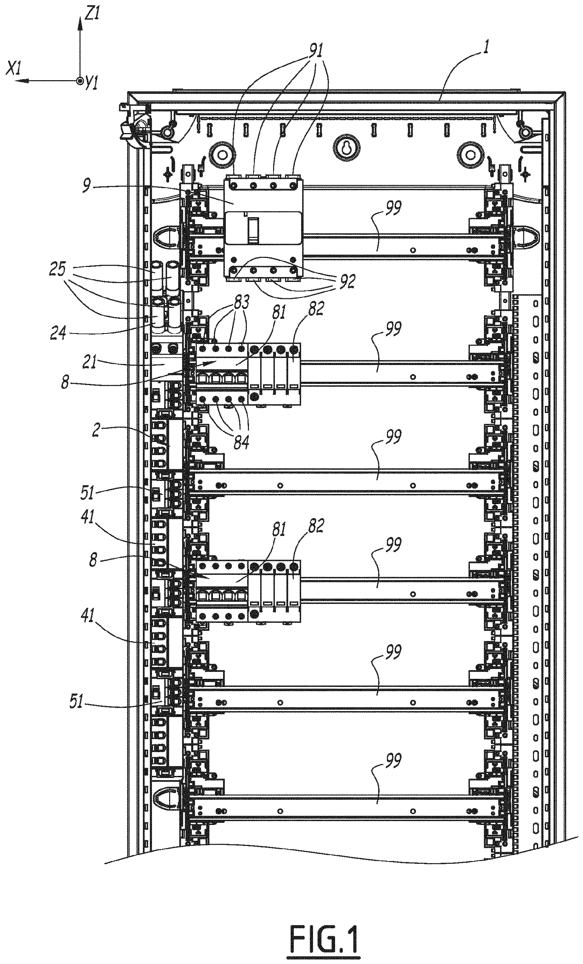

La figure 1 montre un tableau électrique conforme à l'invention. Le tableau électrique est configuré pour être intégré à une installation électrique, équipant par exemple un bâtiment.

De préférence, le tableau électrique comprend un coffret 1, ou une armoire. Le tableau comprend aussi, à l'intérieur du coffret 1, un distributeur de courant électrique 2, plusieurs groupes d'appareils 8, ici deux groupes 8, et, de préférence, un appareil de tête de tableau 9. En variante, l'appareil 9 est disposé hors du coffret 1.

On définit une direction X1, une direction Y1 et une direction Z1, qui sont perpendiculaires entre elles et fixes par rapport au tableau, en particulier par rapport à un boîtier 21 du distributeur 2.

Le distributeur 2, les groupes d'appareils 8 et l'appareil de tête de tableau 9 sont préférentiellement disposés sensiblement dans un même plan, qui est parallèle aux directions X1 et Z1. De préférence, la direction Z1 est verticale et tournée vers le haut.

De préférence, le tableau comprend des rails 99 pour supporter l'appareil 9 et les groupes d'appareils 8. Les rails 99 sont préférentiellement parallèles à la direction X1, en étant répartis suivant la direction Y1 à l'intérieur du coffret 1.

De préférence, le tableau est alimenté en énergie électrique via l'appareil de tête de tableau 9, par un réseau électrique collectif. L'appareil 9 est préférentiellement fixé sur le premier rail 99, placé le plus haut, suivant la direction Z1.

L'appareil 9 est préférentiellement un dispositif de protection électrique, qui peut être mis dans une configuration ouverte par un utilisateur, pour couper l'alimentation électrique du tableau, ou mis dans une configuration fermée par l'utilisateur, pour autoriser l'alimentation électrique tu tableau par le réseau électrique collectif. De préférence l'appareil 9 présente un pouvoir de coupure en embarquant une chambre de coupure d'arcs électriques. L'appareil 9 embarque avantageusement un ou plusieurs déclencheurs, par exemple un déclencheur magnétique, un déclencheur thermique et/ou un déclencheur différentiel, de sorte à passer automatiquement en position ouverte, lorsqu'un défaut électrique correspondant se produit en aval de l'appareil 9. L'appareil 9 constitue ainsi préférentiellement un disjoncteur différentiel. L'appareil 9 comprend des bornes d'entrée 91, par l'intermédiaire duquel il est alimenté en énergie électrique par le réseau électrique collectif, et des bornes de sortie 92, par l'intermédiaire desquelles il alimente le distributeur 2 avec l'énergie électrique du réseau collectif, lorsque l'appareil 9 est en configuration fermée.

On prévoit avantageusement que chaque groupe d'appareils 8 est supporté par un rail 99 respectif. Certains rails 99 peuvent être laissés libres. Chaque groupe d'appareils 8 comprend un appareil de tête de groupe 81, et un ou plusieurs autres appareils 82. En fonction des besoins de l'installation électrique, le nombre, la disposition et la composition des groupes 8 peut être modifiée de façon amovible.

De préférence, chaque groupe d'appareils 8 est alimenté en énergie électrique via l'appareil de tête de groupe 81, avec de l'énergie électrique provenant de l'appareil de tête de tableau 9, par l'intermédiaire du distributeur 2. Chaque appareil 81 est préférentiellement un dispositif de protection électrique, qui peut être mis dans une configuration ouverte par un utilisateur, pour couper seulement l'alimentation électrique du groupe 8 concerné, ou dans une configuration fermée, pour autoriser l'alimentation électrique du groupe 8 concerné. Autrement dit, les groupes 8 sont alimentés en dérivation les uns par rapport aux autres, par l'intermédiaire du distributeur 2. De préférence, en fonction des besoins du groupe 8 concerné, l'appareil 81 présente un pouvoir de coupure en embarquant une chambre de coupure d'arcs électriques, présente préférentiellement un ou plusieurs déclencheurs, par exemple un déclencheur magnétique, un déclencheur thermique et/ou un déclencheur différentiel, de sorte à passer automatiquement en configuration ouverte, lorsqu'un défaut électrique correspondant se produit en aval de l'appareil 81. L'appareil 81 constitue ainsi préférentiellement un disjoncteur différentiel, un disjoncteur magnétothermique, ou un interrupteur différentiel. L'appareil 81 comprend des bornes d'entrée 83, par l'intermédiaire duquel il est alimenté en énergie électrique par le distributeur 2, et des bornes de sortie 84, par l'intermédiaire desquelles il alimente les appareils 82 du groupe 8 concerné, par exemple par l'intermédiaire d'un peigne, non représenté. Au sein d'un même groupe 8, les appareils 82 sont préférentiellement alimentés en dérivation les uns par rapport aux autres par l'appareil 81. Par exemple, chaque appareil 82 est constitué par un disjoncteur magnétothermique, ou un ensemble télérupteur-disjoncteur. Chaque appareil 82 est préférentiellement dédié à l'alimentation d'un circuit respectif de l'installation. Chaque circuit alimente un ou plusieurs appareils récepteurs, hors du coffret 1, tels que de l'éclairage, de l'électroménager, des appareils de chauffage et/ou des machines.

Ici, le réseau électrique collectif fournit l'énergie électrique selon quatre pôles, à savoir un pôle de neutre et trois pôles de phases. Le réseau électrique collectif est donc triphasé. En variante, le réseau électrique collectif pourrait fournir l'énergie électrique selon deux pôles, en étant monophasé, avec un pôle de neutre et un seul pôle de phase. En tous cas, on prévoit au moins un pôle de neutre, et au moins un pôle de phase. L'appareil 9 comprend préférentiellement autant de bornes 91 et 92 que le réseau comprend de pôles. Ici l'appareil 9 comprend donc quatre bornes 91 et quatre bornes 92. Chaque borne 91 est électriquement connectée à un conducteur électrique respectif, non représenté, appartenant au réseau collectif, pour alimenter l'appareil 9. Pour alimenter l'appareil 9, le réseau électrique collectif comprend autant de conducteurs d'alimentation que de pôles, ici quatre conducteurs. Chacun de ces conducteurs est avantageusement reçu dans une borne d'entrée 91 respective de l'appareil 9.

Le distributeur 2 est représenté seul sur les figues 2 à 6. Le boîtier 21 du distributeur 2 est de forme allongée et rectiligne, parallèlement à la direction Z1. Le boîtier 21 forme une enveloppe rigide et fermée. Préférentiellement, le boîtier 21 est électriquement isolant. Le boîtier 21 comprend une extrémité primaire 22 et une extrémité secondaire 23 opposées, réparties suivant la direction Z1 et constituant les extrémités du distributeur 2. L'extrémité 22 est disposée dans la direction Z1 par rapport à l'extrémité 23. Le boîtier 21 comprend avantageusement un flanc de droite 26, un flanc de gauche 27, une façade 28 et un dos 29, reliant l'extrémité 22 à l'extrémité 23 suivant la direction Z1. La façade 28 et le dos 29 relient les flancs 26 et 27 suivant la direction X1. Les flancs 26 et 27 relient la façade 28 et le dos 29 suivant la direction Y1. Les extrémités 22 et 23, les flancs 26 et 27, la façade 28 et le dos 29 sont disposés en parallélogramme et constituent l'enveloppe fermée du boîtier 21. Par exemple, pour que le distributeur 2 soit solidaire avec le tableau, le distributeur 2 est attaché à une extrémité respective de plusieurs des rails 99, ou à des attaches spécifiques solidaires des rails ou du coffret 1. A cette fin, le dos 29 peut présenter des attaches correspondantes. De préférence, le boîtier 21 s'étend perpendiculairement auxdits rails 99, comme montré sur la figure 1.

Le distributeur 2 comprend un bornier d'entrée 24, des borniers de distribution amovibles 41 et, de préférence, des borniers de distribution fixes 51. Pour solidariser les borniers de distribution amovibles 41 avec le boîtier 21, on prévoit avantageusement que le distributeur comprend des socles 47, chaque socle 47 recevant un bornier 41 correspondant.

Le bornier d'entrée 24 est disposé à l'extrémité 22 et est solidaire avec le boîtier 21. C'est par l'intermédiaire de ce bornier 24 que le distributeur 2 est destiné à être alimenté avec de l'énergie électrique provenant du réseau électrique collectif, ici par l'intermédiaire de l'appareil de tête de tableau 9.

Les borniers de distribution 41, lorsqu'ils sont solidaires avec le boîtier 21, et les borniers de distribution 51, sont disposés successivement entre le bornier d'entrée 24 et l'extrémité secondaire 23, en sens opposé de la direction Z1. Autrement dit, les socles 47 et les borniers de distribution 51 sont disposés successivement entre le bornier d'entrée 24 et l'extrémité secondaire 23. Dans l'exemple, on prévoit une alternance entre les borniers 41 et 51, c'est-à-dire que, à partir du bornier 24, on prévoit successivement un bornier 51, puis un bornier 41, puis un bornier 51, etc. Autrement dit, on prévoit une alternance de socles 47 et de borniers 51. Au total, le distributeur 2 du présent exemple comprend quatre borniers de distribution fixes 51, et quatre socles 47, de sorte que quatre borniers de distribution amovibles 41 à la fois peuvent être solidarisés avec le boîtier 21. Plus généralement, on peut prévoir un nombre de borniers de distribution différent de celui du présent exemple, comprenant au moins un bornier de distribution amovible 41, reçu sur son socle 47 respectif. Eventuellement, on ne prévoit aucun bornier de distribution fixe, tous les borniers de distribution étant alors des borniers de distribution amovibles 41.

De préférence le bornier d'entrée 24 est entièrement fixé à demeure, c'est-à-dire de façon permanente ou définitive, sur le boîtier 21. Pour permettre l'alimentation du distributeur 2 en énergie électrique, le bornier 24 comprend plusieurs bornes d'entrée 25, ici quatre. De préférence, on prévoit autant de bornes d'entrée 25 que pôles pour le réseau collectif, à savoir au moins une borne d'entrée 25 pour le pôle de neutre, et une borne d'entrée 25 respective pour chaque pôle de phase. Les bornes 25 sont électriquement isolées les unes des autres. Pour alimenter le distributeur 2 en énergie électrique, chaque borne 25 est électriquement reliée à l'une des bornes de sortie 92 respective de l'appareil 9, par exemple à l'aide d'un conducteur électrique respectif, tel qu'un câble électrique souple, non représenté.

Chaque borne 25 est conçue pour être connectée avec un conducteur électrique filaire, de préférence un câble ou un fil électrique revêtu d'une gaine isolante. Dans l'exemple illustré, chaque borne 25 se présente sous la forme d'une borne à vis. Chaque borne 25 comprend un orifice de réception d'une extrémité du conducteur la reliant à l'appareil 9, cet orifice débouchant depuis la façade 28 ou de l'extrémité 22 du boîtier 21. Lorsque l'extrémité du conducteur électrique est reçue dans l'orifice de réception, elle est mise en contact électrique avec une partie conductrice de la borne 25. Chaque borne 25 comprend une vis de serrage dont une tête est disposée en façade 28, le serrage de la vis opérant un verrouillage de l'extrémité de conducteur reçue dans la cavité, et un desserrage autorisant un retrait de ladite extrémité. En variante, chaque borne peut 25 se présenter sous la forme d'une borne à connecteur rapide, ou sous la forme d'un autre type de borne.

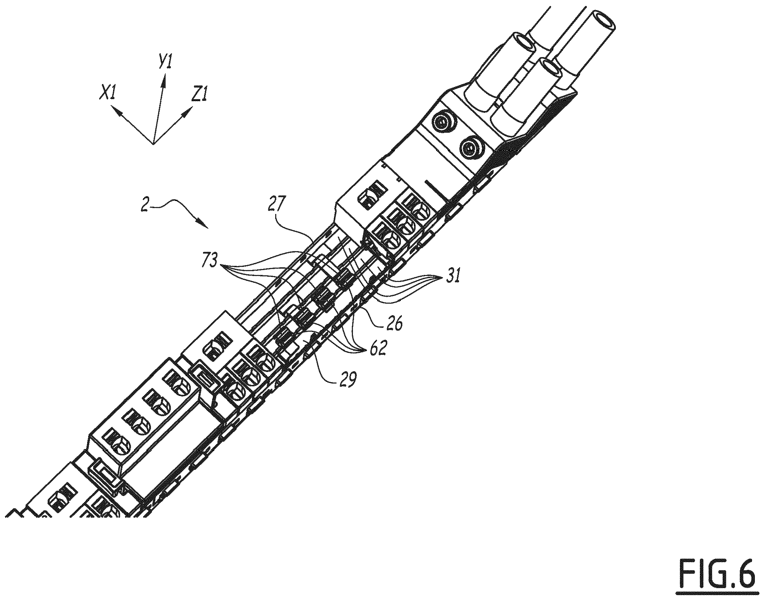

Le distributeur 2 comprend des conducteurs internes 31, qui sont partiellement visibles sur la figure 6, où une partie de la façade 28 est retirée pour montrer l'intérieur du boîtier 21. Chaque conducteur interne 31 est préférentiellement rectiligne sur la majorité, voire sur la totalité de sa longueur, et s'étend parallèlement à la direction Z1. De préférence, les conducteurs 31 sont répartis dans un même plan parallèle aux directions Z1 et X1, en étant espacés les uns des autres suivant la direction X1. Chaque conducteur interne 31 s'étend depuis l'extrémité 22, ou pour le moins depuis le bornier 24, jusqu'à l'extrémité 23, ou pour le moins jusqu'au bornier de distribution 41 ou socle 47 le plus éloigné du bornier 24. Chaque conducteur interne 31 se présente ici sous la forme d'une barre conductrice rigide, notamment une barre métallique de section rectangulaire ou carrée. De préférence, on prévoit autant de conducteurs internes 31 que de bornes d'entrée 25, ici quatre.

Individuellement, chaque borne d'entrée 25 est électriquement connectée à l'un des conducteurs internes 31. Pour cela, par exemple, une partie électriquement conductrice de la borne d'entrée 25 est soudée, ou autrement maintenue en contact électrique, avec le conducteur 31 correspondant. Ainsi, chaque conducteur interne 31, par l'intermédiaire de la borne d'entrée auquel ce conducteur 31 est connecté, véhicule l'énergie électrique de l'un des pôles du réseau électrique collectif, reçue au bornier d'entrée 24.

Chaque bornier de distribution fixe 51 est entièrement fixé à demeure, c'est-à-dire de façon permanente ou définitive, sur le boîtier 21. Chaque bornier 51 peut être utilisé pour alimenter l'un des groupes d'appareils 8 avec de l'énergie électrique reçue au bornier d'entrée 24. A cet effet, chaque bornier 51 comprend plusieurs bornes de distribution 52, ici quatre. De préférence, pour chaque bornier 51, on prévoit autant de bornes de distribution 52 que de bornes 25 et que de conducteurs 31, à savoir une borne 52 pour le pôle de neutre, et une borne 52 respective pour chaque pôle de phase. Les bornes 52 sont électriquement isolées les unes des autres. Pour pouvoir alimenter l'un des groupes d'appareils 8 en énergie électrique, chaque borne 52 est électriquement reliée à l'un des conducteurs internes 31, respectivement, de façon permanente. Pour cela, par exemple, une partie électriquement conductrice interne de la borne 52 est soudée, ou autrement maintenue en contact électrique, de façon non démontable, avec le conducteur 31 correspondant. Plus généralement, on prévoit avantageusement que les bornes 52 ne sont pas détachables du boîtier 21, c'est-à-dire y sont fixées à demeure. Ainsi, chaque borne 52, par l'intermédiaire de la borne d'entrée 25 auquel ce conducteur 31 est connecté, véhicule l'énergie électrique de l'un des pôles du réseau électrique collectif, reçue au bornier d'entrée 24.

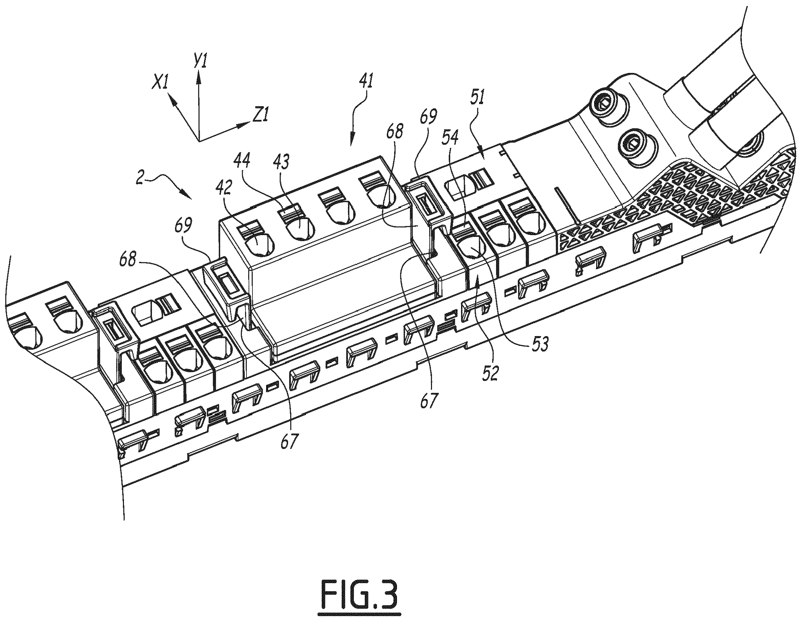

Chaque borne 52 est conçue pour être électriquement connectée à l'une des bornes 83 de l'un des appareils 81. Les bornes 52 d'un même bornier 51 sont respectivement reliées aux bornes 83 d'un même appareil 81. A cet effet, par exemple, chaque borne 52 est conçue pour être connectée avec l'extrémité nue d'un conducteur électrique souple reliant la borne 52 à la borne 83, de préférence un câble ou un fil électrique revêtu d'une gaine isolante. Dans l'exemple illustré, chaque borne 52 se présente sous la forme d'une borne à connexion rapide. Plus précisément, comme montré pour l'une des bornes 52 sur la figure 3, chaque borne 52 comprend un orifice 53 de réception d'une extrémité d'un conducteur électrique, destiné à relier la borne 52 à l'un des groupes 8. Cet orifice 53 est disposé en façade 28. Lorsque l'extrémité du conducteur électrique est reçue au sein de l'orifice 53, elle est mise en contact électrique avec la partie conductrice à l'intérieur de la borne 52. Chaque borne 52 comprend en outre une encoche de déverrouillage 54, qui débouche en façade 28 du boîtier 21, qu'il convient d'actionner avec un outil pour déverrouiller, et ainsi autoriser le retrait, d'une extrémité de conducteur reçue dans l'orifice 53. En variante, chaque borne 52 peut se présenter sous la forme d'une borne à vis, ou sous la forme d'un autre type de borne.

Chaque socle 47 forme avantageusement une partie de la façade 28. Chaque socle 47 forme avantageusement une cavité ouverte dans la direction Y1, pour recevoir l'un des borniers 41 en configuration montée. En particulier, le socle 47 comprend une paroi de fond 61, parallèle aux directions X1 et Y1, électriquement isolante. Les conducteurs internes 31 sont disposés entre la paroi de fond 61 et le dos 29 du boîtier 21. La paroi de fond 61 constitue avantageusement une partie de la façade 28.

En définitive, le distributeur 2 comprend une partie principale, qui n'est pas prévue pour être désassemblée par le technicien, qui inclut le boîtier 21, le bornier 24, les conducteurs internes 31 et, s'ils sont prévus, les borniers 51. En particulier, chaque socle 47 est préférentiellement solidaire du boîtier 21 de façon permanente. Autrement dit, le socle 47 est configuré pour ne pas être démontable vis-à-vis du boîtier 21 par le technicien.

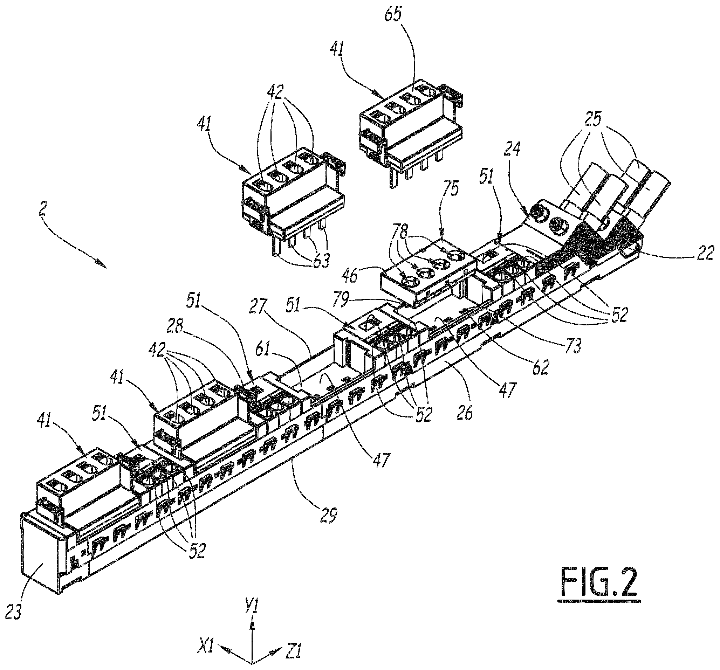

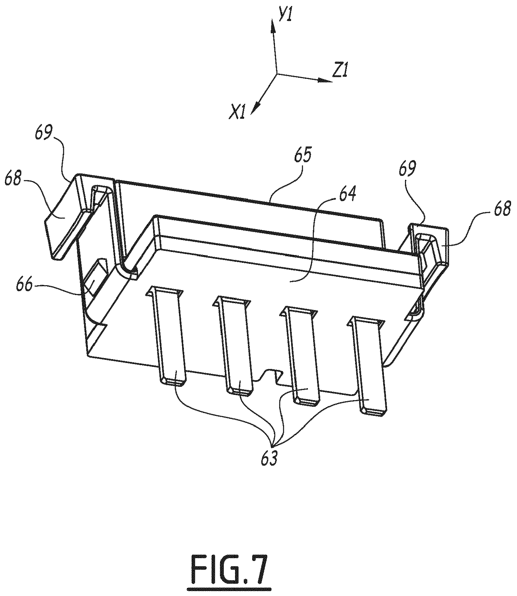

Au contraire, chaque bornier 41 est « amovible » vis-à-vis de cette partie principale, et en particulier vis-à-vis du boîtier 21 et des socles 47. Autrement dit, chaque bornier 41 est individuellement détachable du boîtier 21, de façon réversible, par un technicien, de préférence sans outil. Lorsque le bornier 41 est solidaire du boîtier 21, le bornier 41 est dit dans une « configuration montée ». Les deux borniers 41 montrés à gauche sur la figure 2, ainsi que le bornier 41 de la figure 3, sont représentés en configuration montée. En configuration montée, le bornier 41 est accueilli par l'un des socles 47. En configuration montée, le bornier 41 peut être utilisé pour alimenter l'un des groupes d'appareils 8 avec de l'énergie électrique reçue au bornier d'entrée 24, comme expliqué ci-après. Lorsque le bornier 41 est séparé du boîtier 21 et de tout socle 47, le bornier 41 est dit dans une « configuration libérée », comme montré pour les deux borniers 41 à droite sur la figure 2 et pour le bornier 41 de la figure 7. Lorsque le bornier 41 est dans la configuration libérée, le bornier 41 ne reçoit pas l'énergie électrique du bornier 24 et ne peut donc pas alimenter d'appareil.

Grâce à ce caractère amovible des borniers 41, le distributeur 2 peut être modifié par le technicien lors de l'installation ou plus tard, en choisissant quels socles 47 reçoivent ou non un bornier 41 en configuration montée.

Plus précisément, chaque bornier 41 comprend plusieurs bornes de distribution 42, ici quatre. De préférence, pour chaque bornier 41, on prévoit autant de bornes de distribution 42 que de bornes 25 et que de conducteurs 31, à savoir une borne 42 pour le pôle de neutre, et une borne 42 respective pour chaque pôle de phase. Les bornes 42 sont électriquement isolées les unes des autres. La fonction des bornes 41 est similaire à celle des bornes de distribution 52, lorsque le bornier 41 est en configuration montée.

Le bornier 41 comprend un boîtier individuel, qui forme une enveloppe fermée et rigide, électriquement isolante. Le boîtier individuel du bornier 41 comprend une façade 65, qui est laissée libre, même lorsque le bornier 41 est en configuration installée. La façade 65 s'étend alors en saillie par rapport à la façade 28 dans la direction Y1. Comme montré sur la figure 7, le boîtier du bornier 41 comprend également un fond 64, qui est une paroi opposée à la façade 65 suivant la direction Y1, et qui est tournée en direction de la paroi 61 du socle 47 lorsque le bornier 41 est en configuration installée. La paroi 61 et le fond 64 sont par exemple sensiblement plans, et parallèles aux directions X1 et Z1 lorsque le bornier 41 est en configuration montée.

En configuration libérée, le bornier de distribution amovible 41 est désolidarisé du boîtier 21, en particulier du socle 47. En configuration libérée, le bornier de distribution amovible 41 peut être ultérieurement remonté sur le boîtier 21 pour être remis en configuration montée, sur le même socle 47, ou sur un autre socle 47 non occupé par un autre bornier 41. Alternativement, le bornier 41 peut être remonté sur le boîtier d'un autre distributeur présentant un socle compatible, afin d'être mis en configuration montée sur cet autre distributeur. En configuration libérée, les bornes 42 sont électriquement déconnectées, c'est-à-dire isolées, des conducteurs internes 31, du fait de la séparation physique entre le bornier 41 et la partie principale du distributeur 2. Alors, mêmes si les bornes 42 sont électriquement reliées à un groupe d'appareils 8, les bornes 42 ne peuvent pas alimenter ce groupe 8 avec l'énergie électrique fournie par les conducteurs 31.

En configuration montée du bornier 41, chaque borne de distribution 42 portée par ce bornier 41 est électriquement reliée à l'un des conducteurs internes 31, ici par l'intermédiaire du socle 47. Dans cette configuration montée, les bornes 42 peuvent alimenter l'un des groupes d'appareils 8 en énergie électrique, si l'on relie électriquement les bornes 42 au groupe d'appareil 8 souhaité. Alors, chaque borne 42 véhicule l'énergie électrique de l'un des pôles du réseau électrique collectif, reçue au bornier d'entrée 24, via l'un des conducteurs 31.

Chaque borne 42 est conçue pour être électriquement connectée à l'une des bornes 83 de l'un des appareils 81. Les bornes 42 d'un même bornier 41 sont respectivement reliées aux bornes 83 d'un même appareil 81. A cet effet, par exemple, chaque borne 42 est conçue pour être connectée avec un conducteur électrique souple, de préférence un câble ou un fil électrique revêtu d'une gaine isolante. Dans l'exemple illustré, chaque borne 42 se présente sous la forme d'une borne à connexion rapide. Plus précisément, comme montré pour l'une des bornes 42 sur la figure 3, chaque borne 42 comprend un orifice 43 de réception d'une extrémité d'un conducteur électrique, destiné à relier la borne 42 à l'un des groupes 8. Cet orifice 43 est avantageusement débouchant depuis la façade 65 dans la direction Y1. Les orifices 43, voire les bornes 42 en entier, sont avantageusement répartis parallèlement à la direction Z1. Lorsque l'extrémité du conducteur électrique est reçue au sein de l'orifice 43, elle est mise en contact électrique avec une partie conductrice à l'intérieur de la borne 42. Chaque borne 42 comprend avantageusement une encoche de déverrouillage 44, qui débouche en façade 65, qu'il convient d'actionner avec un outil pour déverrouiller, et ainsi autoriser le retrait, d'une extrémité de conducteur reçue dans l'orifice 43. En variante, chaque borne 42 peut se présenter sous la forme d'une borne à vis, ou sous la forme d'un autre type de borne.

Pour que les bornes 42 portées par le bornier de distribution amovible 41 soient électriquement connectées aux conducteurs 31 lorsque le bornier 41 est en configuration montée, chaque socle 47 comprend des connecteurs femelles 62 et chaque borne 42 du bornier 41 comprend un connecteur mâle 63 respectif correspondant. Pour un bornier 41 et son socle 47, on prévoit autant de connecteurs 62 que de bornes 42. Ici, on prévoit donc quatre connecteurs 62 et quatre connecteurs 63, formant quatre paires de connecteurs, pour chaque couple bornier-socle.

Chaque connecteur femelle 62 est électriquement relié à l'un des conducteurs internes 31 de façon permanente. Chaque connecteur femelle 62 véhicule donc le courant électrique reçu au bornier d'entrée 25.

Dans le présent exemple, chaque connecteur femelle 62 comprend une pince conductrice et un orifice, prévu au travers de la paroi 61 du socle 47, la pince étant atteinte par le connecteur mâle 63 correspondant, au travers dudit orifice lorsque le bornier 41 est en configuration montée. Les pinces sont notamment visibles sur la figure 6, où la paroi de fond 61 du socle 47 est omise. Chaque connecteur femelle 62 est solidaire de façon permanente avec la partie principale. Chaque pince forme une pièce électriquement conductrice, connectée au conducteur interne 31. En particulier, chaque pince est ici soudée, ou autrement maintenue au contact électrique de l'un des conducteurs internes 31, et chaque orifice est formé directement dans la paroi 61. De préférence, chaque connecteur 62 est tourné dans la direction Y1 pour recevoir le connecteur 63 correspondant, qui est lui tourné en sens opposé. Les connecteurs 62 sont préférentiellement répartis de façon alignée parallèlement à la direction Z1, ou pour le moins, sont répartis en correspondance avec les bornes 42.

Chaque connecteur mâles 63 comprend ici une fiche respective, électriquement conductrice. Chaque connecteur mâle 63, en particulier, sa fiche, fait saillie du fond 64 du bornier 41, en sens inverse de la direction Y1. La fiche, et plus généralement, le connecteur 63, est soudée, ou autrement maintenue au contact de la pièce conductrice appartenant à la même borne 42 du bornier 41, à l'intérieur du boîtier dudit bornier 41, de façon permanente. Alternativement, le connecteur 63 est venu de matière avec cette pièce conductrice. En correspondance avec les connecteurs 62, les connecteurs 63 sont avantageusement répartis parallèlement à la direction Z1.

Lorsque l'on fait passer le bornier 41 de la configuration libérée à la configuration montée, chaque connecteur 63 pénètre dans le connecteur 62 correspondant en sens opposé de la direction Y1. Ici, chaque fiche est donc enfichée dans l'une des pinces. La connexion électrique du bornier 41 s'effectue donc selon un système fiche-socle, ici parallèle à la direction Y1, et est donc particulièrement aisée. Cette connexion réalisée, chaque borne 42 est électriquement reliée à l'un des conducteurs internes 31 lorsque le bornier 41 est en configuration montée. Lorsque l'on fait passer le bornier 41 de la configuration montée à la configuration libérée, chaque connecteur 63 est séparé de son connecteur 62 correspondant, ce qui interrompt la connexion électrique.

Le boîtier individuel du bornier 41 présente une forme mâle complémentaire avec la forme en creux du socle 47. Par exemple, la forme mâle du boîtier du bornier 41 est de forme générale parallélépipédique, tout comme la forme en creux du socle 47. La disposition des connecteurs 63 et/ou la forme du boîtier du bornier 41 servent avantageusement de détrompeur en rotation autour d'un axe parallèle à la direction Y1. Autrement dit, en configuration montée, le bornier 41 ne peut prendre qu'une seule orientation autour de cet axe, par rapport au boîtier 21, par complémentarité de forme entre le bornier 41 et le socle 47. La disposition et la forme des connecteurs 62 et 63 peut participer à cette complémentarité.

De préférence, le distributeur 2 comprend avantageusement des moyens d'encliquetages pour assurer un verrouillage du bornier 41 sur le socle 47, lorsque ledit bornier 41 est en configuration montée. Une partie des moyens d'encliquetage est formée par le socle 47, ou pour le moins par le boîtier 21, alors qu'une autre partie des moyens d'encliquetage, complémentaire, est formée par le bornier 41.

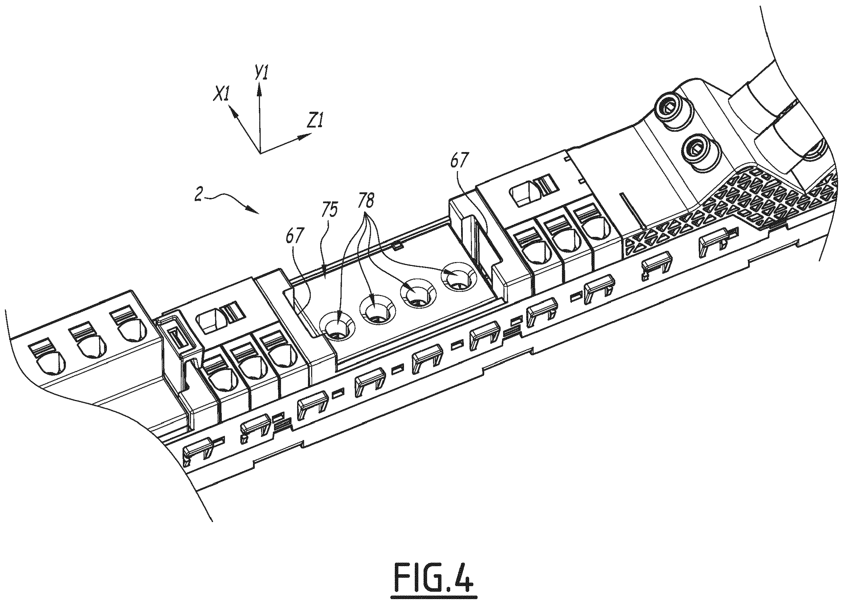

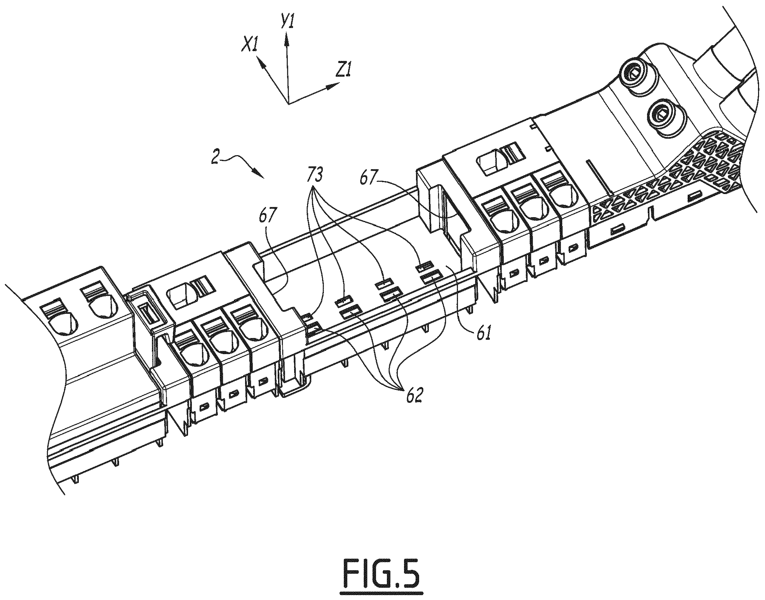

Ici, on prévoit deux paires de moyens d'encliquetage pour chaque couple bornier-socle. Chaque paire de moyens d'encliquetage comprend par exemple une dent 66, visible sur la figure 7, portée par le boîtier du bornier 41, et une dent 67 complémentaire, visible sur les figures 4 et 5, appartenant au socle 47. Dans l'exemple, chaque dent 66 est portée à une extrémité longitudinale respective du boîtier individuel du bornier 41, c'est-à-dire des extrémités suivant la direction Z1. De façon correspondante, chaque dent 67 est portée à une extrémité longitudinale respective du socle 47, de part et d'autre de la paroi de fond 61, c'est-à-dire des extrémités suivant la direction Z1. Ici, les dents 66 sont tournées vers l'extérieur, pour coopérer avec les dents 67 qui sont tournées vers l'intérieur.

Lorsque l'on fait passer le bornier 41 depuis la configuration libérée jusqu'à la configuration montée, les dents 66 viennent s'accrocher avec les dents 67, de sorte à empêcher un retrait du bornier 41 suivant la direction Y1 par rapport au boîtier 21. Autrement dit, en configuration montée, les dents 66 et 67 sont encliquetées pour maintenir le bornier 41 solidaire avec le boîtier 21, et ainsi maintenir la connexion électrique des bornes 42 avec les conducteurs 31 correspondants.

Dans l'exemple, chaque paire de moyens d'encliquetage comprend également un bras de déverrouillage 68, ici porté par le boîtier du bornier 41, et portant la dent 66, comme montré sur la figure 7. Les bras 68 sont prévus aux extrémités longitudinales opposées du bornier 41. Par exemple, chaque bras 68 est rattaché au boîtier du bornier 41 à proximité du fond 64. Comme visible notamment sur la figure 3, chaque bras 68 présente une extrémité libre 69 opposée à ce rattachement, qui est accessible pour être actionnée par le technicien, lorsque le bornier 41 est en configuration montée. Par rapport au rattachement, l'extrémité 69 est dirigée approximativement dans la direction Y1. Par l'intermédiaire de cette extrémité libre 69, chaque bras 68 peut être élastiquement déformé par le technicien depuis une configuration de verrouillage, montrée sur les figures, qui est adoptée lorsque les dents 66 et 67 sont encliquetées, jusqu'à une configuration de déverrouillage, non représentée, pour désencliqueter les dents 66 et 67. Par élasticité, le bras 68 tend à revenir dans la configuration de verrouillage lorsqu'il est mis en configuration de déverrouillage. Dans l'exemple, depuis la configuration de verrouillage, la configuration de déverrouillage est atteinte par pivotement du bras 68 autour de son rattachement, c'est-à-dire autour d'un axe parallèle à la direction X1, avec déplacement de l'extrémité 69 en direction du boîtier du bornier 41. Autrement dit, dans l'exemple, il convient de rapprocher les extrémités 69 l'une de l'autre suivant la direction Z1 pour déverrouiller le bornier 41. Les bras 68 peuvent être mis en configuration de déverrouillage par le technicien pour désencliqueter les dents 66 et 67 et ainsi pouvoir retirer le bornier 41 suivant la direction Y1 par rapport au boîtier 21, mettant ainsi le bornier 41 en configuration libérée.

Le distributeur 2 comprend préférentiellement au moins un module de surveillance 46, dont un exemple est visible sur les figures 2, 4 et 8.

Tout comme les borniers 41, le ou les modules 46 sont amovibles vis-à-vis de la partie principale du distributeur 2, en particulier vis-à-vis du boîtier 21 et des socles 47. Chaque module 46 est individuellement détachable du boîtier 21, de façon réversible, par un technicien, de préférence sans outil. Lorsque le module 46 est solidaire du boîtier 21, le module 46 est dit dans une « configuration installée », comme montré sur la figure 4. Lorsque le module 46 est séparé du boîtier 21, le module 46 est dit dans une « configuration désinstallée ». Chaque bornier 41 peut être mis en configuration montée sur un socle 47 donné, que le module 46 soit en configuration installée ou en configuration désinstallée sur ce socle 47. Autrement dit, le bornier 41 peut alimenter le groupe d'appareils 8 en présence et en l'absence du module 46 sur le socle 47.

Lorsque le bornier 41 est en configuration montée et que le module 46 est en configuration installée sur le même socle 47, le module 46 est configuré pour récolter et transmettre des données concernant le courant électrique circulant au travers du bornier 41, en particulier au niveau d'une ou plusieurs de ses bornes 41, ou l'absence éventuelle d'un tel courant électrique. Autrement dit, le module 46 mesure une ou plusieurs grandeurs électriques aux bornes de distribution 42 de l'un des borniers 41 et transmet tout ou partie des grandeurs mesurées, ou de données issues de ces grandeurs, à un dispositif tiers. Par exemple, le module 46 peut mesurer une consommation électrique, une puissance instantanée, ou d'autres grandeurs électriques, aux bornes 42 du bornier 41.

Grâce à ce caractère amovible des modules 46, qui peuvent être accouplés ou non avec tout ou partie des borniers 41, le distributeur 2 peut être modifié par le technicien lors de l'installation ou plus tard, en choisissant quels borniers 41 en configuration installée comporte un module 46 pour effectuer des mesures.

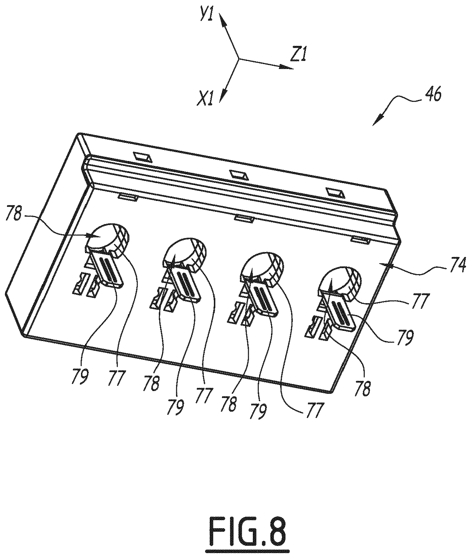

En détails, comme mieux visible sur les figures 4 et 8, le module 46 comprend préférentiellement un boîtier individuel, qui forme une enveloppe fermée et rigide, électriquement isolante. Ce boîtier est de forme complémentaire avec le socle 47, ici de forme générale parallélépipédique.

Le boîtier individuel du module 46 comprend une façade 75, qui est laissée libre lorsque le module 46 est en configuration installée sans que le bornier 41 soit en configuration montée. Lorsque le bornier 41 est en configuration montée, le fond 64 et la façade 75 sont en regard, voir en appui l'une contre l'autre, dans le sens de la direction Y1.

Le boîtier du module 46 comprend également un fond 74, visible sur la figure 8, opposé à la façade 75 suivant la direction Y1, et qui est tourné en direction de la paroi 61 du socle 47 lorsque le module 46 est en configuration installée. De préférence, le fond 74 et la paroi 61 sont alors en appui l'une contre l'autre parallèlement à la direction Y1, le fond 74 étant préférentiellement sensiblement plan et parallèle à la paroi 61.

En configuration installée, le module 46 est accueilli par l'un des socles 47. De préférence, en configuration installée, en l'absence du bornier 41, le module 46 n'est pas fixé suivant la direction Y1. Si ce socle 47 accueille également un bornier 41 en configuration montée, alors le module 46 est avantageusement disposé, suivant la direction Y1, entre le bornier 41 et les conducteurs internes 31, en particulier entre le bornier 41 et le socle 47. Plus précisément, le module 46 est disposé entre la paroi 61 et le fond 64, qui sont distants l'un de l'autre suivant la direction Y1, pour ménager un logement pour le module 46. Dans cette situation, le module 46 est reçu dans la forme en creux du socle 47 et est recouvert par le bornier 41. Alors, le module 46 est maintenu solidaire avec le boîtier 21 et le bornier 41 en étant ainsi interposé entre eux. Le module 46 est donc avantageusement dépourvu de moyens de maintien qui lui sont propres, contrairement au bornier 41 disposant des moyens d'encliquetage. De préférence, il est possible de mettre le bornier 41 en configuration montée même en l'absence du module 46 sur le socle 47. Alors, le volume ménagé entre les parois 61 et 64 est avantageusement laissé libre.

En configuration désinstallée, le module 46 est désolidarisé du boîtier 21, en particulier du socle 47 et du bornier 41. En configuration désinstallée, le module 46 peut être ultérieurement remonté sur le boîtier 21 pour être remis en configuration installé, sur le même socle 47, ou sur un autre socle 47 non occupé par un autre module 46. Alternativement, le module 46 peut être remonté sur le boîtier d'un autre distributeur présentant un socle compatible, afin d'être mis en configuration installée sur cet autre distributeur.

Le module 46 comprend avantageusement des conduits traversants 78, ici au nombre de quatre. Pour chaque module 46, on prévoit avantageusement autant de conduits 78 que le bornier 41 comprend de bornes 42, en particulier de connecteurs mâles 63. Chaque conduit 78 débouche en façade 75 et au fond 74, et s'étend parallèlement à la direction Y1. Chaque conduit 78 est respectivement traversé par l'un des connecteurs mâles 63 du bornier 41, lorsque ledit bornier 41 est en configuration montée et que le module 46 est en configuration installée sur le même socle. Autrement dit, chaque conduit 78 est individuellement traversé par une partie conductrice de l'une des bornes 42. Le courant électrique alimentant chaque borne 42 et provenant de chaque conducteur interne 31 circulant le long d'un chemin de conduction qui traverse le module 46 de part en part, le chemin de conduction incluant ici par le connecteur mâle 63. Cela facilite la conception du module 46 pour la mesure de la grandeur électrique tout en assurant la compacité de l'ensemble.

A l'intérieur de son boîtier individuel, le module 46 comprend des moyens électroniques, qui incluent des capteurs 77 pour mesurer la grandeur électrique.

Chaque capteur 77 est disposé le long de l'un des conduits 78, pour pouvoir mesurer la grandeur électrique lorsque le conduit 78 reçoit le connecteur mâle 63 correspondant. La mesure de la grandeur électrique aux bornes 42 est ainsi effectuée auprès des connecteurs mâles 63. Par exemple, chaque capteur 77 comprend un bobinage, tel qu'un enroulement de Rogowski, pour permettre une mesure précise du courant électrique circulant au sein du connecteur mâle 63. Alors, l'enroulement de Rogowski entoure le connecteur mâle 63 traversant le conduit 78 correspondant, en s'étendent sur le pourtour interne du conduit 78. Toutefois d'autres types de capteurs peuvent être prévus.

De préférence, pour chaque module 46, on prévoit seulement trois capteurs 77, pour mesurer une grandeur électrique respective pour trois des connecteurs 63, à savoir les connecteurs 63 correspondant aux trois bornes 42 véhiculant les trois phases. Autrement dit, l'un des connecteurs 63, véhiculant le neutre, n'est pas mesuré. En cas d'installation monophasée, on pourrait donc prévoir un seul capteur 77 pour mesurer la borne 42 véhiculant l'unique phase. Toutefois, en fonction du type de mesure à effectuer, on peut prévoir de mesurer chaque bornes 42 avec un capteur respectif appartenant au module 46, ou toute borne 42 souhaitée avec un nombre et un agencement de capteurs approprié au sein du module 46.

De préférence, les moyens électroniques contenus dans le boîtier du module 46 comprennent en outre une carte électronique, un analyseur électronique et un transmetteur électronique, non illustrés.

La carte électronique, notamment de type circuit imprimé ou « Printed Circuit Board », « PCB » en langue anglaise, est fixée à l'intérieur du boîtier du module 46. La carte électronique sert à la fois de support mécanique pour certains composants, notamment pour l'analyseur électronique, le transmetteur électronique et les capteurs 77, tout en comportant un ou plusieurs circuits électriques assurant les connexions électriques entre les différents moyens électroniques qui l'équipent et/ou qui y sont connectés. De préférence, la carte électronique est orientée parallèlement aux directions X1 et Z1, en étant en appui, de préférence sur son pourtour, contre les parois du boîtier du module 46.

Chaque capteur 77 est avantageusement fixé au autrement intégré à la carte électronique, par exemple en comprenant un ou plusieurs composants électroniques soudés sur la carte électronique et/ou un agencement de pistes conductrices sur la carte électronique.

L'analyseur électronique est un système électronique, comportant par exemple un processeur mettant en œuvre un code informatique stocké sur une mémoire. L'analyseur se présente sous la forme d'un ou plusieurs composants électroniques montés sur la carte électronique et électroniquement interconnectés. Fonctionnellement, l'analyseur est conçu pour déterminer une information, par traitement de la mesure effectuée par les capteurs 77. Pour cela, les capteurs 77 sont électroniquement reliés à l'analyseur électronique via les circuits de la carte électronique. Par exemple, si les capteurs 77 mesurent le courant circulant au sein des bornes 42, l'analyseur peut effectuer un comptage de l'énergie électrique ayant été délivrée par le bornier 41 au groupe d'appareils 8, ou encore détecter s'il existe un déséquilibre entre l'intensité du courant circulant dans l'une des bornes 42 vis-à-vis de l'intensité du courant circulant dans une autre borne 42 du bornier 41.

Le transmetteur électronique est un système électronique, comportant par exemple un processeur mettant en œuvre un code informatique stocké sur une mémoire. Le transmetteur se présente sous la forme d'un ou plusieurs composants électroniques montés sur la carte électronique et électroniquement interconnectés. Le transmetteur électronique constitue avantageusement un système électronique distinct de l'analyseur électronique, mais un seul composant électronique pourrait alternativement embarquer le transmetteur électronique et l'analyseur électronique.

L'information déterminée par l'analyseur électronique est électroniquement transmise au transmetteur électronique, par l'intermédiaire du circuit de la carte électronique. Le transmetteur électronique est conçu pour transmettre l'information, ou tout autre donnée, fournie par l'analyseur électronique, à un dispositif tiers distant du distributeur 2, soit contenu dans le tableau, soit hors du tableau. Pour cela, le transmetteur électronique comprend par exemple un émetteur sans fil, tel qu'un émetteur radio comprenant une antenne. Pour transmettre l'information, on prévoit préférentiellement que le transmetteur électronique émet un message radio, c'est-à-dire une trame, qui contient l'information en question. De préférence, on prévoit un seul dispositif tiers, pour recevoir et centraliser les informations reçues de tous les modules 46 du distributeur 2, et les retransmettre ensuite à un utilisateur ou au technicien.

De préférence, le module 46 comprend des connecteurs d'alimentation 79, ici au nombre de quatre, visibles sur la figure 8. C'est par l'intermédiaire de ces connecteurs 79 que le module 46 peut être alimenté en énergie électrique, pour le fonctionnement de ses moyens électroniques. Grâce à la présence de ces connecteurs 79, il n'est préférentiellement pas nécessaire de prévoir une réserve d'énergie embarquée pour l'alimentation électrique des moyens électronique.

Pour l'alimentation électrique du module 46, on prévoit que les connecteurs 79 sont respectivement connectés à l'un des conducteurs internes 31 lorsque le module 46 est en configuration installée. Alors, le module de surveillance 46 est alimenté avec du courant électrique reçu au bornier d'entrée 24 pour son fonctionnement. Pour cela, comme visible sur la figure 5, chaque socle 47 comprend préférentiellement des connecteurs 73, complémentaires avec les connecteurs 79. Ici, les connecteurs 73 sont des connecteurs femelle, alors que les connecteurs 79 sont des connecteurs mâles. Pour un module 46 et son socle 47, on prévoit avantageusement autant de paires de connecteurs 73 et 79 que de bornes 42. Ici, pour chaque couple module-socle, on prévoit donc quatre connecteurs 73 et quatre connecteurs 79, formant quatre paires de connecteurs.

Chaque connecteur mâle 79 forme avantageusement une fiche électriquement conductrice, de façon similaire aux connecteurs mâles 63. Chaque connecteur mâle 79 est électriquement raccordé aux moyens électroniques du module 46, de façon permanente, de préférence via la carte électronique. Les connecteurs mâles 79 sont avantageusement répartis parallèlement à la direction Z1, et font saillie du fond 74 du module 46 en sens opposé de la direction Y1, comme visible sur la figure 8. De préférence, chaque connecteur 79 est disposé au bord de l'un des conduits 78, ou à proximité, par exemple dans la direction X1 par rapport à ce conduit. De préférence, les connecteurs 79 sont répartis parallèlement à la direction Z1, en correspondance avec les bornes 42 et avec les connecteurs 73.

Chaque connecteur femelle 73 est électriquement relié à l'un des conducteurs internes 31 de façon permanente. Chaque connecteur femelle 73 est même solidaire de façon permanente avec la partie principale du distributeur 2. Chaque connecteur femelle 73 véhicule donc le courant électrique reçu au bornier d'entrée 24.

Comme visible sur la figure 6, dans le présent exemple, chaque connecteur femelle 73 comprend une patte conductrice, solidaire de la pince conductrice de l'un des connecteurs femelles 62. Chaque connecteur femelle 73 comprend aussi un orifice ménagé au travers de la paroi 61, au travers duquel la patte conductrice peut être atteinte par le connecteur mâle 79, lorsque le module 46 est en configuration installée. Suivant la direction Y1, la patte conductrice est disposée entre la paroi 61 et les conducteurs 31. Plus précisément, alors que la pince conductrice du connecteur femelle 62 comprend deux mâchoires conductrices, entre lesquelles le connecteur mâle 63 est reçu, l'une de ces deux mâchoires sert de pièce conductrice appartenant au connecteur 73. Le connecteur mâle 79 vient avantageusement en contact électrique contre cette mâchoire de la pince conductrice, ce qui raccorde électriquement le connecteur mâle 79 au conducteur 31 correspondant. Ainsi, en configuration installée du module 46 et en configuration montée du bornier 41, cette mâchoire de la pince conductrice se trouve interposée entre le connecteur mâle 79 et le connecteur mâle 63, parallèlement à la direction X1. Suivant la direction X1, se succèdent la première mâchoire du connecteur 62, le connecteur mâle 63, la deuxième mâchoire du connecteur 62 formant également la pièce conductrice du connecteur 73, et enfin le connecteur mâle 79.

Lorsque l'on fait passer le module 46 de la configuration désinstallée à la configuration installée, chaque connecteur 79 pénètre dans le connecteur 73 correspondant en sens opposé de la direction Y1. Ici, chaque fiche est donc enfichée au travers de l'un des orifices appartenant aux connecteurs 73 et entre en contact électrique avec l'une des mâchoires de la pince conductrice correspondante. La connexion électrique du module 46 avec le socle 47 s'effectue donc selon un système fiche-socle, ici parallèle à la direction Y1, et est donc particulièrement aisée. Cette connexion réalisée, chaque borne connecteur 79 est électriquement relié à l'un des conducteurs internes 31 lorsque le module 46 est en configuration installée. Lorsque l'on fait passer le module 46 de la configuration installée à la configuration désinstallée, chaque connecteur 79 est séparé de son connecteur 73 correspondant, ce qui interrompt la connexion électrique.

De préférence, la complémentarité du boîtier du module 46 avec le socle 47 et la disposition des connecteurs 73 et 79 constituent un détrompeur, qui impose que le module 46 peut être reçu par le socle 47 selon une seule orientation, afin d'éviter un montage incorrect du module 46 sur le boîtier 21.

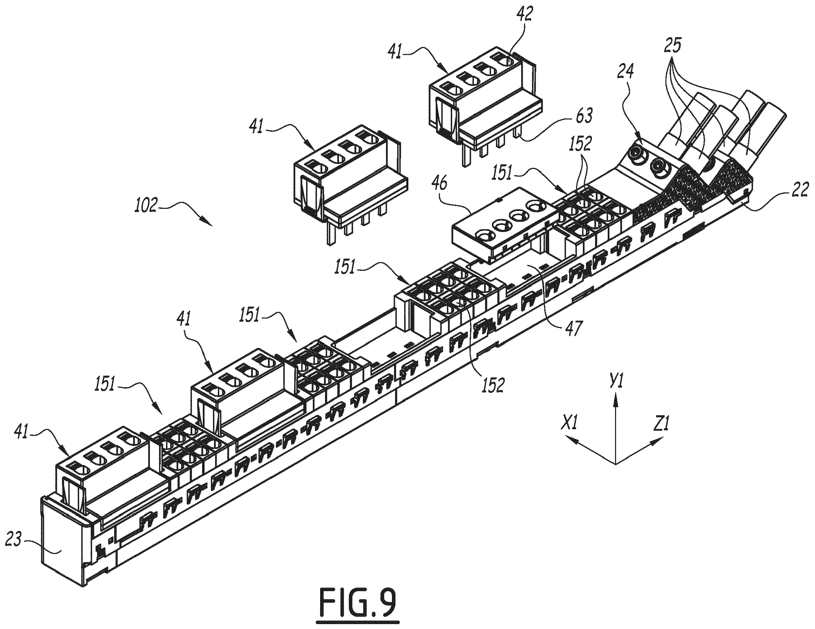

Le distributeur de courant électrique 102 du deuxième mode de réalisation montré sur la figure 9 est identique au distributeur 2 du mode de réalisation illustré sur les figures 1 à 8, hormis pour les différences mentionnées ci-après. Sur les figures 1 à 9, les éléments communs entre les deux modes de réalisation sont désignés par les mêmes signes de référence. Les éléments distincts mais de fonction voisine sont désignés, pour le mode de réalisation de la figure 9, avec un signe de référence augmenté de 100, par rapport au signe de référence correspondant pour les figures 1 à 8.

Le distributeur 102 comprend, des borniers de distribution fixe 151, en remplacement des borniers de distribution fixe 51 prévus pour le distributeur 2.

Comme pour les borniers 52, chaque bornier de distribution fixe 151 est entièrement fixé à demeure, c'est-à-dire de façon permanente ou définitive, sur le boîtier 21. Contrairement aux borniers 51, qui sont conçus pour l'alimentation d'un seul groupe d'appareils 8, chaque bornier 151 peut être utilisé pour alimenter plusieurs groupes d'appareils 8 avec de l'énergie électrique reçue au bornier d'entrée 24. Ici, chaque bornier 151 peut alimenter deux groupes d'appareils 8 à la fois. A cet effet, chaque bornier 151 comprend deux groupes de plusieurs bornes de distribution 152, chaque groupe de bornes 152 étant conçu pour alimenter un groupe d'appareils 8 respectif. Ici, quatre bornes 152 sont prévus pour chaque groupe. Pour chaque bornier 151, on prévoit autant de bornes de distribution 152 que de bornes 25 et que de conducteurs 31, à savoir une borne 152 pour le pôle de neutre, et une borne 152 respective pour chaque pôle de phase. Les bornes 152 sont électriquement isolées les unes des autres. Par exemple, on prévoit que les bornes 152 d'un même groupe de bornes sont réparties parallèlement à la direction Z1, et débouchent dans la direction Y1. Au sein d'un même bornier 151, les groupes de bornes sont répartis parallèlement à la direction X1. Ici, pour chaque bornier 151, on obtient donc deux rangées de bornes 152, parallèles à la direction Z1.

Au sein de chaque bornier 151, chaque groupe de bornes 152 a la même fonction qu'un seul des borniers 51, à savoir d'alimenter un groupe d'appareils 8 avec du courant électrique reçu au bornier d'entrée 24. Autrement dit, chaque bornier 151 peut alimenter deux groupes d'appareils 8, chacun à l'aide d'un groupe de bornes 152. Par conséquent, davantage de groupes d'appareils peuvent être alimentés par le distributeur 102 que par le distributeur 2, sensiblement dans le même encombrement. Industriellement, il est aisément concevable de produire le distributeur 2 et le distributeur 102 en ne changeant que les borniers de distribution fixe 151 et 51, sans modifier le reste du distributeur, notamment le boîtier 21, pour obtenir deux gammes de distributeurs, où les distributeurs sont adaptés à une taille ou un type respectif de tableau électrique respectifs.

Pour chaque groupe de bornes 152, chaque borne 152 est électriquement reliée à l'un des conducteurs internes 31, respectivement, de façon permanente. Autrement dit, chaque conducteur interne 31 est électriquement connecté à deux bornes 152 du même bornier 151, appartenant chacune à un groupe de bornes différent. Grâce à ces connexions, chaque groupe de bornes 152 peut alimenter l'un des groupes d'appareils 8 en énergie électrique. Pour que la borne 152 soit électriquement connectée au conducteur interne 31, par exemple, une partie électriquement conductrice interne de la borne 152 est soudée, ou autrement maintenue en contact électrique, de façon non démontable, avec le conducteur 31 correspondant. Plus généralement, on prévoit avantageusement que les bornes 152 ne sont pas détachables du boîtier 21, c'est-à-dire y sont fixées à demeure. Ainsi, chaque borne 152, par l'intermédiaire de la borne d'entrée 25 auquel ce conducteur 31 est connecté, véhicule l'énergie électrique de l'un des pôles du réseau électrique collectif, reçue au bornier d'entrée 24.

De la même façon que les bornes 52, chaque borne 152 est conçue pour être électriquement connectée à l'une des bornes 83 de l'un des appareils 81. Les bornes 152 appartenant au même groupe de bornes du bornier 151 sont respectivement reliées aux bornes 83 d'un même appareil 81. A cet effet, par exemple, chaque borne 152 est conçue pour être connectée avec l'extrémité nue d'un conducteur électrique souple reliant la borne 152 à la borne 83, de préférence un câble ou un fil électrique revêtu d'une gaine isolante. Dans l'exemple illustré, chaque borne 152 se présente sous la forme d'une borne à connexion rapide, de structure identique à la borne 52 montrée sur la figure 3.

Les caractéristiques décrites ci-dessus pour un mode de réalisation ou une variante peuvent être mises en œuvre dans les autres modes de réalisation décrits ci-avant, pour autant que techniquement possible.

## Revendications

1. Distributeur de courant électrique (2; 102) pour un tableau électrique, le distributeur de courant électrique (2; 102) comprenant :
- un boîtier (21), qui comprend une extrémité primaire (22) et une extrémité secondaire (23) opposées ;
- des conducteurs internes (31), qui sont contenus dans le boîtier (21) ;
- un bornier d'entrée (24), par l'intermédiaire duquel le distributeur de courant électrique (2; 102) est destiné à être alimenté avec du courant électrique, le bornier d'entrée (24) étant solidaire du boîtier (21) en étant positionné à l'extrémité primaire (22) et comprenant, pour chaque conducteur interne (31), une borne d'entrée (25) respective qui est électriquement reliée à ce conducteur interne (31) ; et
- des borniers de distribution (41, 51; 41, 151), chaque bornier de distribution (41, 51 ; 41, 151) comprenant, pour chaque conducteur interne (31), une borne de distribution (42, 52; 42, 152) respective, chaque bornier de distribution (41, 51 ; 41, 151) étant conçu pour alimenter un appareil de tête de groupe (81) respectif appartenant au tableau électrique, avec du courant électrique reçu au bornier d'entrée (24), par l'intermédiaire des bornes de distribution (42, 52 ; 42, 152) dudit bornier de distribution (41, 51 ; 41, 151) ;
**caractérisé en ce qu'**au moins l'un des borniers de distribution (41, 51; 41, 151) constitue un bornier de distribution amovible (41), qui est configuré pour évoluer entre :
- une configuration montée, dans laquelle le bornier de distribution amovible (41) est solidaire du boîtier (21), en étant disposé entre le bornier d'entrée (24) et l'extrémité secondaire (23), et dans laquelle chaque borne de distribution (42) du bornier de distribution amovible (41) est électriquement reliée à l'un des conducteurs internes (31) respectif pour que le bornier de distribution amovible (41) soit alimenté avec du courant électrique reçu aux bornes d'entrée (25), et
- une configuration libérée, dans laquelle le bornier de distribution amovible (41) est désolidarisé du boîtier (21) et dans laquelle les bornes de distribution (42) du bornier de distribution amovible (41) sont électriquement déconnectées des conducteurs internes (31).

2. Distributeur de courant électrique (2; 102) selon la revendication 1, dans lequel,
- le distributeur de courant électrique (2; 102) comprend, pour chaque borne de distribution (42) du bornier de distribution amovible (41), un connecteur femelle (62) respectif, qui est électriquement relié à l'un des conducteurs internes (31), que le bornier de distribution amovible (41) soit en configuration montée ou en configuration libérée ; et
- chaque borne de distribution (42) du bornier de distribution amovible (41) comprend un connecteur mâle (63) respectif, chaque connecteur mâle (63) formant préférentiellement une fiche respective et étant :
• électriquement connecté avec l'un des connecteurs femelle (62) en étant enfiché dans ledit connecteur femelle (62), lorsque le bornier de distribution amovible (41) est en configuration montée, pour relier électriquement la borne de distribution (42) au conducteur interne (31) auquel ledit connecteur femelle (62) est électriquement relié, et
• électriquement déconnecté dudit connecteur femelle (62) lorsque le bornier de distribution amovible (41) est en configuration libérée.

3. Distributeur de courant électrique (2; 102) selon l'une quelconque des revendications précédentes, dans lequel :
- le distributeur de courant électrique (2; 102) comprend un module de surveillance (46), qui est configuré pour évoluer entre :
• une configuration installée, dans laquelle le module de surveillance (46) est solidaire du boîtier (21) et dans laquelle, lorsque le bornier de distribution amovible (41) est en configuration montée, le module de surveillance (46) est configuré pour mesurer une grandeur électrique aux bornes de distribution (42) dudit bornier de distribution amovible (41), et
• une configuration désinstallée, dans laquelle le module de surveillance (46) est désolidarisé du boîtier (21) ; et
- le bornier de distribution amovible (41) est configuré pour pouvoir être en configuration montée, que le module de surveillance (46) soit en configuration installée ou en configuration désinstallée.

4. Distributeur de courant électrique (2; 102) selon la revendication 3, dans lequel, lorsque le module de surveillance (46) est en configuration installée et que le bornier de distribution amovible (41) est en configuration montée, le module de surveillance (46) est intercalé entre le bornier de distribution amovible (41) et les conducteurs internes (31).

5. Distributeur de courant électrique (2; 102) selon l'une quelconque des revendications 3 ou 4, dans lequel :
- le module de surveillance (46) comprend un conduit traversant (78) ; et
- lorsque le bornier de distribution amovible (41) est en configuration montée et que le module de surveillance (46) est en configuration installée, le conduit traversant (78) est traversé par l'une des bornes de distribution (42) du bornier de distribution amovible (41).

6. Distributeur de courant électrique (2; 102) selon la revendication 5, dans lequel le module de surveillance (46) comprend un capteur (77), qui est disposé le long du conduit traversant (78) pour mesurer la grandeur électrique auprès de la borne de distribution (42) qui traverse ledit conduit traversant (78).

7. Distributeur de courant électrique (2; 102) selon l'une quelconque des revendications 3 à 6, dans lequel le module de surveillance (46) comprend des connecteurs d'alimentation (79), chaque connecteur d'alimentation (79) étant électriquement relié à l'un des conducteurs internes (31), lorsque le module de surveillance (46) est en configuration installée, le module de surveillance (46) étant alors alimenté avec du courant électrique reçu au bornier d'entrée (24) par l'intermédiaire des conducteurs internes (31) et des connecteurs d'alimentation (79).

8. Distributeur de courant électrique (2; 102) selon l'une quelconque des revendications précédentes, dans lequel le distributeur de courant électrique (2; 102) comprend des moyens d'encliquetage (66, 67), qui sont encliquetés pour maintenir le bornier de distribution amovible (41) solidaire avec le boîtier (21) lorsque le bornier de distribution amovible (41) est en configuration montée, et qui peuvent être désencliquetés pour faire passer le bornier de distribution amovible (41) en configuration libérée.

9. Distributeur de courant électrique (2; 102) selon l'une quelconque des revendications précédentes, dans lequel :
- au moins l'un des borniers de distribution (41, 51 ; 41, 151) constitue un bornier de distribution fixe (51 ; 151), qui est solidaire du boîtier (21) de façon permanente, en étant disposé entre le bornier d'entrée (24) et l'extrémité secondaire (23) ;
- chaque borne de distribution (52 ; 152) du bornier de distribution fixe (51 ; 151) est électriquement reliée à l'un des conducteurs internes (31) respectif, de façon permanente.

10. Tableau électrique, comprenant :
- un distributeur de courant électrique (2; 102) selon l'une quelconque des revendications précédentes ; et
- au moins un groupe d'appareils (8), chaque groupe d'appareils (8) comprenant un appareil de tête de groupe (81) respectif, par l'intermédiaire duquel le groupe d'appareils (8) est électriquement relié aux bornes de distribution (42, 52 ; 42, 152) de l'un des borniers de distribution (41, 51; 41, 151), pour que le groupe d'appareils (8) soit alimenté avec de l'énergie électrique reçue aux bornes d'entrée (25) par l'intermédiaire dudit bornier de distribution (41, 51 ; 41, 151).
